# EUROPEAN PATENT SPECIFICATION

(11) **EP 4 328 600 B1**
(45) Date of publication and mention of the grant of the patent: **02.09.2026**
(21) Application number: 22901752.0
(22) Date of filing: 30.11.2022
(51) Int. Cl.: G01R 31/36, H01M 10/42

(54) **TAB GUIDE AND TAB GUIDE DEVICE COMPRISING TAB GUIDE**
LASCHENFÜHRUNG UND LASCHENFÜHRUNGSVORRICHTUNG MIT LASCHENFÜHRUNG
GUIDE DE LANGUETTE ET DISPOSITIF DE GUIDAGE DE LANGUETTE COMPRENANT UN GUIDE DE LANGUETTE

(30) Priority: 01.12.2021 KR 20210169787
(43) Date of publication of application: 28.02.2024
(73) Proprietor: LG ENERGY SOLUTION, LTD., Seoul 07335 (KR)
(72) Inventor: KIM, Jae Man, Daejeon 34122 (KR)
(74) Representative: Hoffmann Eitle
(86) International application number: PCT/KR2022/019167
(87) International publication number: WO 2023/101394

(56) References cited:
- JP-A- 2018 125 228
- JP-B2- 6 800 419
- KR-A- 20140 027 751
- KR-A- 20150 050 210
- KR-A- 20180 085 664
- KR-A- 20180 091 323
- US-A1- 2016 172 636

## Description

### [Technical Field]

The present invention relates to a tab guide and a tab guide device including the tab guide.

This application claims the benefit of priority based on Korean Patent Application No. 10-2021-0169787, filed on December 1, 2021.

### [Background Art]

A secondary battery is manufactured by injecting an electrolyte, which is a liquid electrolyte, in a state in which an electrode assembly is accommodated in a battery container, and then sealing the battery container.

In a secondary battery whose manufacturing is completed, various defects due to various causes during an assembly process, a manufacturing process, or use can occur. Among the above, a phenomenon in which a battery whose manufacturing is completed exhibits a voltage drop behavior greater than or equal to a self-discharge rate is called low voltage.

This low-voltage defect phenomenon is typically caused by metallic foreign substances located in the battery, and representatively, when a metallic foreign material is present in a positive electrode, the metallic foreign substances grow into dendrites at a negative electrode, and these dendrites cause an internal short circuit (short) of the secondary battery. As a result, the internal short circuit of the secondary battery causes a breakdown, damage, ignition, and the like of the secondary battery.

Specifically, the low-voltage defect phenomenon often occurs during assembly of secondary batteries. Types of assembly defects which cause the low voltage include separator damage such as separator tears, separator folding, separator punctures, or the like. This separator damage mainly occurs at the four corner portions of a cell body during a manufacturing process of the battery.

Although the above-described defects can cause an internal short circuit, that is, a short circuit in which the positive electrode and the negative electrode come into contact with each other, the positive electrode and the negative electrode are not currently in contact with each other due to a thickness of the separator, but since the short circuit can occur at any time, it is necessary to identify defects by pressing the corresponding portion to cause the internal short circuit.

Conventionally, in order to quickly and accurately identify the low-voltage defects for a large number of battery cells, a method, in which inspection is possible in a short time by applying jig pressing-type pressing short circuit inspection to a plurality of uncharged battery cells in a short time, or the like is used.

Meanwhile, in order to determine a short circuit inside the battery cell, a lead of the battery cell should be electrically connected to a tester pin to detect the electrical characteristics of the battery cell in real time, and a tab guide (chuck) or the like which stably guides and connects the lead of the battery cell to the tester pin is used. JP 2018125228 A1 discloses a chuck device for electrically connecting electrode tabs of a plurality of batteries for testing or the like. US 2016/172636 A1 discloses a guide device for straightening electrodes of a battery while the battery is being inserted into a testing device.

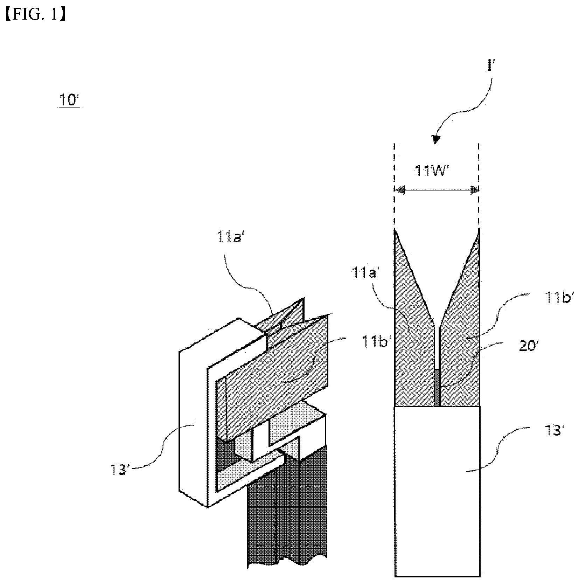

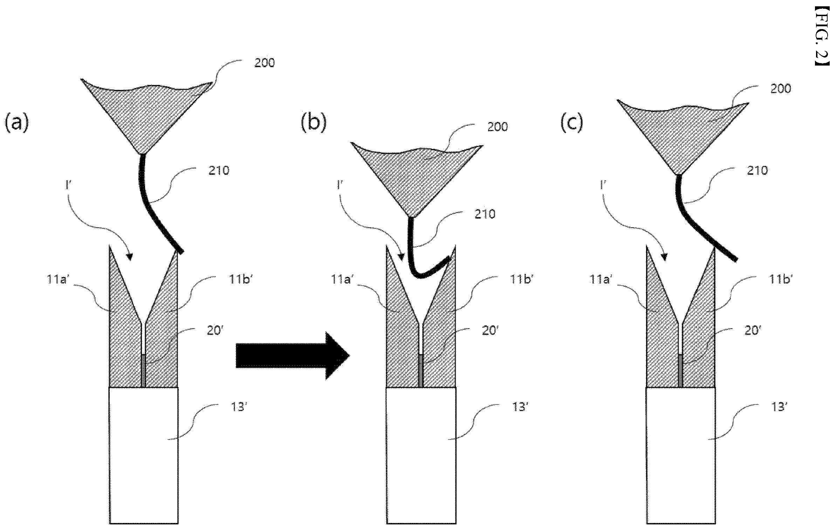

FIG. 1 illustrates a configuration of a conventional tab guide 10'. Referring to FIG. 1, a pair of guide members 11a' and 11b' fixed by a support block 13' have a structure of being spread in a frontward direction, and thus serve to guide a lead 210 of a battery cell 200 to a tester pin 20' interposed between the guide members 11a' and 11b'so that the lead 210 of the battery cell 200 is connected to the tester pin 20'. However, since there is a limitation to a spread angle according to characteristics of the structure of the guide members 11a' and 11b', there is a problem in that a width 11W' of an insertion portion I' into which the lead 210 of the battery cell 200 is inserted is formed relatively narrow. In FIG. 2, problem cases which occur when the lead 210 of the battery cell 200 is inserted into the tab guide 10' having the same structure as FIG. 1 are shown. As shown in FIG. 2(a), when the lead 210 of the battery cell 200 is bent in one direction, a case in which the lead 210 is caught in a process of inserting the lead 210 into the insertion portion I', and thus the lead 210 cannot reach the tester pin 20' can occur (FIG. 2(b)). Further, a problem in that the lead 210 of the battery cell 200 is bent at an inlet of the insertion portion I' in the beginning, and thus insertion into the insertion portion I' is impossible can occur (FIG. 2(c)).

In order to solve the problems caused by the tab guide 10' having the above-described structure in FIG. 1, a method of widening the width 11W' of the insertion portion I' by increasing the degree of spread of the guide members 11a' and 11b' was also used.

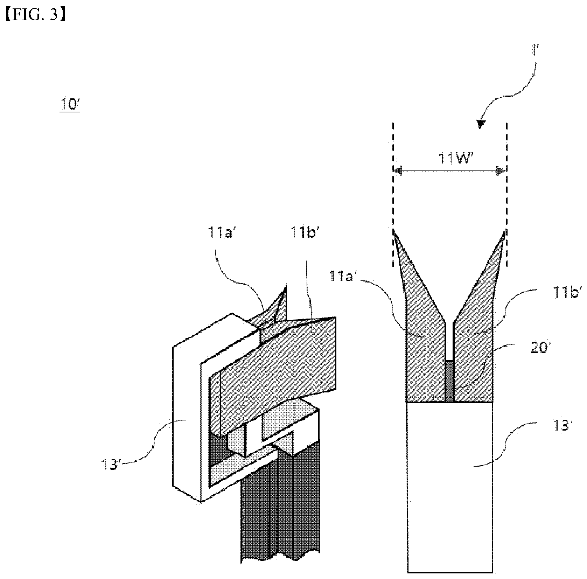

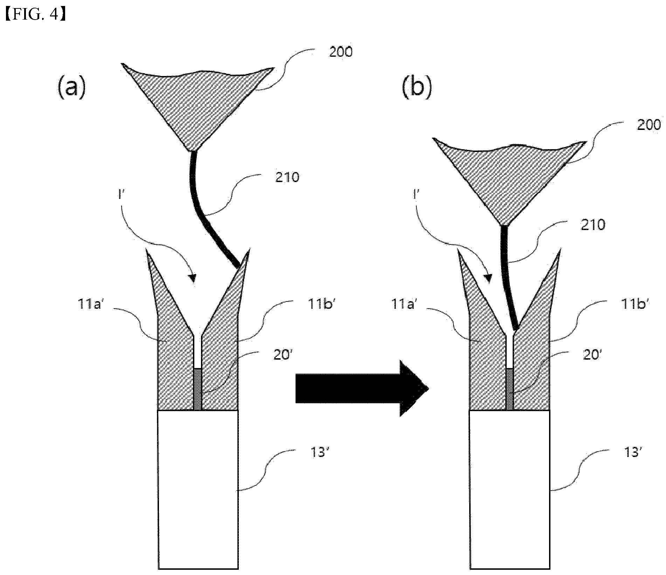

FIG. 3 illustrates a configuration of a conventional tab guide 10' in which a width 11W' of an insertion portion of the tab guide 10' is relatively widened. In the tab guide 10' in FIG. 3, the degree of spread of guide members 11a'and 11b' is increased, and thus the width 11W' of the insertion portion becomes relatively greater than that of the tab guide 10' in FIG. 1. As the tab guide 10' having the structure in FIG. 3 is used, as shown in FIG. 4(a), it can be seen that the guide members 11a' and 11b' guide a lead 210, which is bent and thus is difficult to be inserted, to a tester pin 20' (FIG. 4(b)).

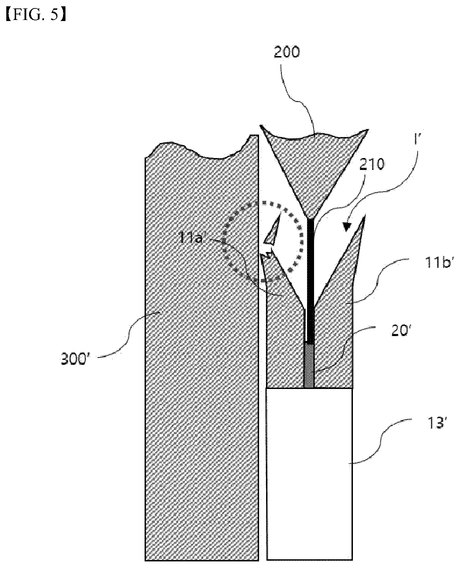

However, in the tab guide 10' having the structure in FIG. 3, when pressing short circuit inspection for a large number of battery cells 200 is performed, a problem in that the guide members 11a' and 11b' collide with the guide members 11a' and 11b' of a neighboring tab guide 10' or a pressing plate 300' and thus are damaged as shown in FIG. 5 due to a unique structure of being spread to side surfaces of the tab guide 10' frequently occurs.

### [Related Art Documents]

Korean Laid-open Patent No. 10-2020-0059563

Japanese Registration Patent No. 6800419

### [Disclosure]

### [Technical Problem]

The present invention is directed to providing a tab guide capable of stably performing electrical characteristic inspection for a large number of battery cells.

Further, the present invention is directed to providing a tab guide capable of guiding a battery cell lead to a tester pin without damaging the battery cell lead.

### [Technical Solution]

According to the present invention, there is provided a tab guide according to claim 1 for guiding an electrode lead of a battery cell to a tester pin for inspection of the battery cell including: a guide member composed of a pair of guide pieces disposed side by side at a predetermined interval and facing each other and having the tester pin installed in the interval, wherein inner side surfaces of the pair of guide pieces facing each other include guide surfaces inclined toward the tester pin from front end portions of the guide pieces; and a pair of extending guide members installed to protrude from the guide member to be inclined away from each other toward the front of the guide member.

Specifically, rear end portions of the pair of extending guide members may be coupled to the guide surfaces of the guide pieces, and the pair of extending guide members may protrude from the guide member at the same angle as an inclination angle of the guide surfaces.

Further, the pair of guide pieces may respectively have vertical inner side surfaces extending from the guide surfaces and disposed to face each other in parallel, the tester pin may be fixedly installed between rear end portions of the vertical inner side surfaces facing each other, and front end portions of the vertical inner side surfaces facing each other may form a fixing part configured to fix the electrode lead.

In addition, outer side surfaces at opposite sides from the inner side surfaces of the pair of guide pieces facing each other may be formed as vertical surfaces extending parallel to the vertical inner side surfaces.

Meanwhile, the tab guide of the present invention may further include a support block coupled to a rear surface of the guide member.

Further, the tab guide may further include a support coupled to a lower portion of the support block and formed to extend in a downward direction.

Specifically, the rear end portions of the pair of extending guide members may be coupled to the front end portions of the guide pieces.

More specifically, the pair of extending guide members may protrude from the guide member at an angle the same as or different from an inclination angle of the guide surfaces.

Meanwhile, the guide member and the extending guide members may be formed of different materials.

For example, the guide member may be formed of a metal material.

Further, the extending guide members may be formed of a material having elasticity.

According to the present invention, there is provided a tab guide device including: a plurality of tab guides of the present invention installed side by side along an arrangement direction of a plurality of battery cells; and a connection member installed to allow the plurality of tab guides to slide, and extending along the arrangement direction of the battery cells.

### [Advantageous Effects]

According to the present invention, in performing pressing short circuit inspection for battery cells, a problem in that a lead of the battery cell does not come into contact with a tester pin and becomes defective can be solved.

Further, the present invention has an effect in that each tab guide is not damaged and stable short circuit inspection can be performed when the short circuit inspection is performed by pressing a large amount of battery cells.

### [Brief Description of the Drawings]

FIG. 1 schematically illustrates a perspective view and a plan view of a conventional tab guide.
FIG. 2 exemplifies problems which occur due to the structure of the tab guide in FIG. 1.
FIG. 3 schematically illustrates a perspective view and a plan view of a tab guide in an improved form of the tab guide in FIG. 1.
FIG. 4 exemplifies a process of connecting a battery cell lead to the tab guide in FIG. 3.
FIG. 5 exemplifies problems which occur due to the structure of the tab guide in FIG. 3.
FIG. 6 illustrates a perspective view and a plan view of a guide member and extending guide members of a tab guide according to a first embodiment of the present invention.
FIG. 7 illustrates a perspective view and a plan view of the tab guide according to the first embodiment of the present invention.
FIG. 8 is an example illustrating an effect of the tab guide of the present invention.
FIG. 9 illustrates a perspective view and a plan view of a tab guide according to a second embodiment of the present invention.

### [Detailed Description of the Preferred Embodiments]

Hereinafter, detailed configurations of the present invention will be described in detail with reference to the accompanying drawings and various embodiments. The embodiments to be described below are exemplified for helping understanding of the present invention, and the accompanying drawings are not drawn to an actual scale for helping the understanding of the present invention, and dimensions of some components may be shown to be exaggerated.

Since the present invention may be variously changed and may have various forms, specific embodiments will be exemplified in the drawings and described in detail in the text. However, it should be understood that this is not intended to limit the present invention to a specific disclosed form. The scope of the invention is defined by the appended claims.

The present invention relates to a tab guide which guides a lead of a battery cell to a tester pin to inspect the electrical characteristics of the battery cell and the like, and a tab guide device including the tab guide. Specifically, the present invention mainly provides a tab guide in which a width of an insertion portion for a battery cell lead is increased using an extending member of a flexible material.

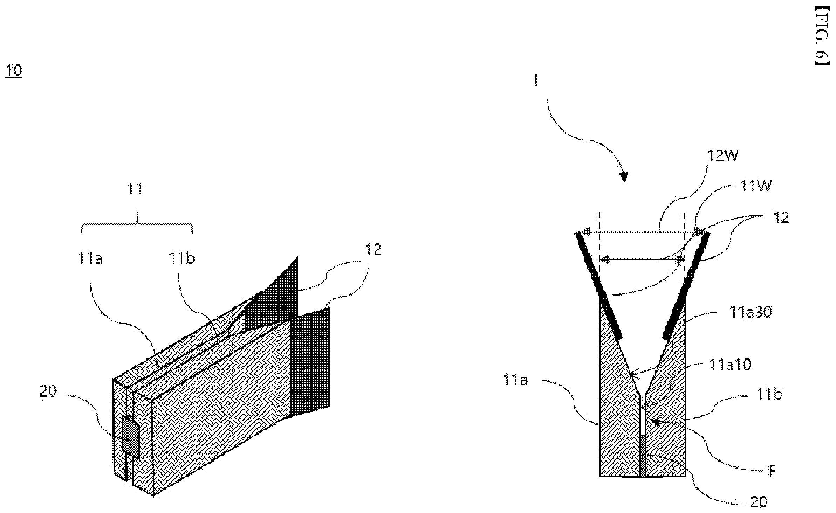

Hereinafter, a configuration of a tab guide according to various embodiments of the present invention will be described, and then a configuration of a tab guide device of the present invention will be described with reference to FIGS. 6 to 8.

### Tab guide

A tab guide of the present invention for guiding an electrode lead of a battery cell to a tester pin for battery cell inspection includes a guide member composed of a pair of guide pieces disposed side by side at a predetermined interval and facing each other and having the tester pin installed in the interval, wherein inner side surfaces of the pair of guide pieces facing each other include guide surfaces inclined toward the tester pin from front end portions of the guide pieces, and a pair of extending guide members installed to protrude from the guide member to be inclined away from each other toward the front of the guide member.

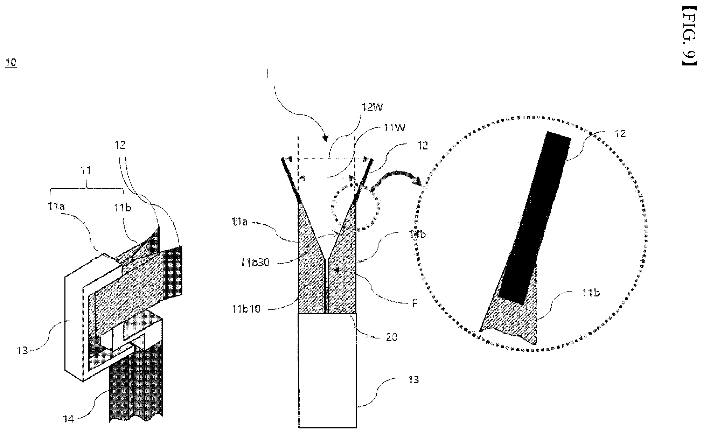

Specifically, various embodiments may be derived according to the installation position, the shape, and the like of the extending guide member, and hereinafter, tab guides of two embodiments will be described with reference to FIGS. 6 and 9.

### (First embodiment)

FIG. 6 illustrates a perspective view and a plan view of a guide member 11 and extending guide members 12 included in a tab guide 10 according to a first embodiment of the present invention.

The tab guide 10 of the present invention includes the guide member 11 including a pair of guide pieces 11a and 11b which guide an electrode lead 210 of a battery cell 200 to a tester pin 20, and a pair of extending guide members 12 installed to protrude from the guide member 11 to be inclined away from each other toward the front of the guide member.

Referring to FIG. 6, it can be seen that the guide member 11 is composed of a pair of guide pieces 11a and 11b disposed side by side at a predetermined interval and facing each other, and inner side surfaces of the pair of guide pieces 11a and 11b facing each other include guide surface 11a30 and 11b30 inclined toward the tester pin 20 from front end portions of the guide pieces 11a and 11b.

The tester pin 20 of the present invention is a device connected to the lead 210 of the battery cell 200 to measure the electrical characteristics of the battery cell 200, and may be disposed to be interposed between the pair of guide pieces 11a and 11b disposed to be spaced apart from each other at the predetermined interval. In this case, the tester pin 20 may be interposed at the rear end portion of the guide member 11.

The tester pin 20 may be connected to measurement equipment (not shown) for measuring the electrical characteristics of the battery cell 200 through a conductive wire (not shown), and the like, and the electrical connection between the tester pin 20 and the measurement equipment is not particularly limited in the present invention.

The pair of guide pieces 11a and 11b have a form of being spread in a frontward direction in which the lead 210 of the battery cell 200 is inserted. Specifically, the inner side surfaces of the guide pieces 11a and 11b include the guide surfaces 11a30 and 11b30 inclined toward the tester pin 20 from the front end portions of the guide pieces 11a and 11b, and include vertical inner side surfaces 11a10 and 11b10 extending from the guide surfaces 11a30 and 11b30 and disposed to face each other in parallel.

In the pair of guide pieces 11a and 11b spaced apart from each other, a separation distance between the guide surfaces 11a30 and 11b30 decreases toward the rear end of the facing guide pieces 11a and 11b, and the separation distance between the guide surfaces 11a30 and 11b30 increases toward the front end of the facing guide pieces 11a and 11b. Since the vertical inner side surfaces 11a10 and 11b10 are formed to extend from the guide surfaces 11a30 and 11b30 at a portion where the separation distance between the guide surfaces 11a30 and 11b30 becomes the shortest, a gap between the vertical inner side surfaces 11a10 and 11b10 of the pair of guide members 11 is formed to be very narrow.

The tester pin 20 is fixedly installed between the rear end portions of the vertical inner side surfaces 11a10 and 11b10 facing each other, and the front end portions of the vertical inner side surfaces 11a10 and 11b10 facing each other may form a fixing part F which fixes the electrode lead 210.

At the front of the tab guide 10, the lead 210 of the battery cell 200 inserted to be connected to the tester pin 20 included in the tab guide 10 moves to a correct position (a position facing the tester pin 20) along the guide surfaces 11a30 and 11b30 when not located at the correct position. In this case, the lead 210, which has moved to the correct position along the guide surfaces 11a30 and 11b30, may be fixed by entering the fixing part F, and may come into contact with the tester pin 20.

Outer side surfaces at opposite sides from the inner side surfaces of the pair of guide pieces 11a and 11b facing each other are formed as vertical surfaces extending parallel to the vertical inner side surfaces 11a10 and 11b10. Specifically, it is preferable that the outer side surfaces of the pair of guide pieces 11a and 11b remain horizontal to each other, and this is to prevent damage to the guide pieces 11a and 11b by colliding with a neighboring tab guide 10 or a pressing plate which presses the battery cell 200 in a process of performing a pressing short circuit test on a large amount of battery cells 200.

The tab guide 10 of the present invention further includes extending guide members 12 formed of a flexible material and having elasticity.

The extending guide members 12 are installed on the guide pieces to protrude to the front of the guide member 11.

Specifically, rear end portions of the pair of extending guide members 12 may be coupled to the guide surface 11a30 and 11b30 of the guide pieces 11a and 11b, and thus the pair of extending guide members 12 may be formed to protrude from the guide member 11 at the same angle as an inclination angle of the guide surfaces 11a30 and 11b30.

The rear end portions of the pair of extending guide members 12 may be coupled to the front end portions of the guide pieces 11a and 11b.

The pair of extending guide members 12 may be formed to protrude from the guide member 11 at an angle the same as or different from the inclination angle of the guide surfaces 11a30 and 11b30. The inclination angle of the guide surfaces 11a30 and 11b30 is fixed by the design of the guide pieces 11a and 11b, but inclination angles of the extending guide members 12 may be freely changed by adjusting the installation positions and shape of the extending guide members 12.

Generally, a section between front ends of the guide member 11 may be a limiting section capable of guiding the lead 210 of the battery cell 200 to the fixing part F. That is, the probability of guiding the lead 210 of the battery cell 200 to the fixing part F increases as a width 11W of the guide member is larger.

In the present invention, the limiting section may be widened through the extending guide members 12. Specifically, the width between the extending guide members 12 extending from the guide surfaces 11a30 and 11b30 and protruding to the front of the guide member 11 may be greater than the width between the guide members 11. As a result, since the limiting section capable of guiding the lead 210 of the battery cell 200 to the fixing part F is larger, the possibility that the tab guide 10 of the present invention guides the lead 210 of the battery cell 200 to the fixing part F and the lead 210 is connected to the tester pin 20 increases.

In the present invention, the guide member 11 and the extending guide members 12 may be formed of different materials.

While the guide member 11 may be formed of a metal material, the extending guide members 12 may be formed of a material having elasticity.

The extending guide members 12 are formed to extend to the guide surfaces 11a30 and 11b30 of the guide member 11 and protrude from the guide member 11, and thus may be directly exposed to external impacts. Accordingly, when a material not having elasticity is used in the extending guide members 12, damage such as a crack, breaking, or the like of the extending guide members 12 may occur in the above-described situation. For example, the extending guide members 12 of the present invention may include a material such as polycarbonate which can recover even from an external impact.

The tab guide 10 of the present invention may further include a support block 13 coupled to the rear surfaces of the guide member 11 and a support 14 formed to be coupled to a lower portion of the support block 13 to extend in a downward direction.

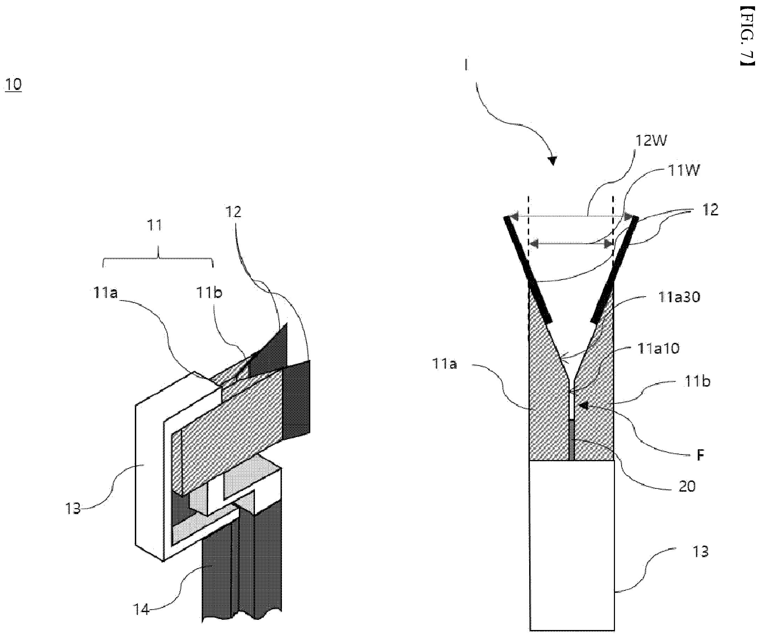

FIG. 7 illustrates a perspective view and a plan view of the tab guide 10 of the present invention to which the support block 13 and the support 14 are applied.

Referring to FIG. 7, the tab guide 10 of the present invention includes the guide member 11 formed to extend in a frontward direction where the lead 210 of the battery cell 200 is located, the support block 13 coupled to rear ends of the guide member 11 to fix the guide member 11, and the support 14 coupled to the lower portion of the support block 13 to extend in the downward direction.

A shape of the support block 13 is not limited to the drawings shown in the present invention, and may be any shape which can fix the guide member 11 and does not interfere with the insertion of the lead 210 of the battery cell 200. Further, the support 14 is not necessarily limited to the drawings shown in the present invention, and may have a shape capable of supporting the support block 13 and moving the support block 13 in a lateral direction.

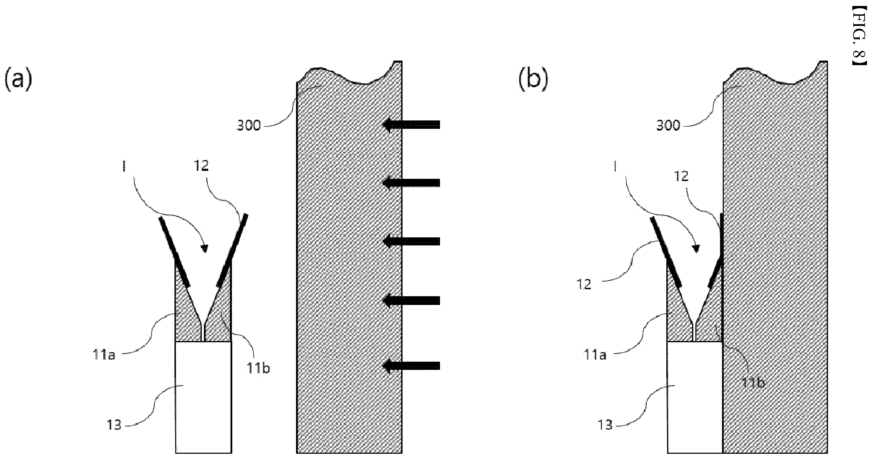

FIG. 8 is an example illustrating an effect of the tab guide 10 of the present invention.

The extending guide members 12 of the present invention are formed of a material having elasticity, and thus may be bent without being broken or cracked by an external impact.

Referring to FIG. 8, it can be seen that a side surface of the tab guide 10 is pushed by the pressing plate. In this case, when the extending guide members 12 do not have elasticity, a problem of being cracked or broken may have occurred. However, the extending guide members 12 of the present invention are only bent by the pressing plate and may be restored to an original state through elasticity.

### (Second embodiment)

FIG. 9 illustrates a perspective view and a plan view of a tab guide 10 according to a second embodiment of the present invention.

Referring to FIG. 9, it can be seen that extending guide members 12 are coupled to the front ends of guide pieces 11a and 11b to be installed to protrude in a frontward direction. That is, rear ends of the extending guide members 12 may be inserted into and coupled to grooves (not shown) formed in upward and downward directions along the front ends of the guide pieces 11a and 11b.

A spread angle of the extending guide members 12 may be changed according to an angle of the grooves formed at front end portions of the guide pieces 11a and 11b. As described above, the width 12W of the extending guide members formed by the extending guide members 12 may be adjusted by changing the angle of the extending guide members 12.

When the tab guide 10 has the structure shown in FIG. 9, inclination angles of the extending guide members 12 may be relatively freely adjusted without being limited to the angle of the guide surfaces 11a30 and 11b30 of the guide member 11.

### Tab guide device

A tab guide device of the present invention includes the tab guide of the present invention.

Specifically, in the tab guide device, a plurality of tab guides may be installed side by side along an arrangement direction of a plurality of battery cells.

The tab guide device is a means capable of simultaneously connecting leads of the battery cells and a tester pin when a large number of battery cells are disposed in a row.

The tab guide device may further include a connection member in which a plurality of tab guides are slidably installed and extend along the arrangement direction of the battery cells (a transverse direction).

The connection member is a member which passes through one end of the support included in the tab guide and allows the tab guide to move in the transverse direction along the connection member. The connection member may have a structure capable of moving the tab guide in the transverse direction, and is not particularly limited in the present invention.

In the above, the present invention has been described in more detail with reference to the drawings, examples, and the like. However, the configuration described in the drawings, embodiments, or the like described in the present specification is only one embodiment of the present invention and it should be understood that there may be various equivalents and modifications at the time of filing the present application. The scope of protection is defined by the appended claims.

### [Reference numerals]

10: tab guide
10': (Related art) tab guide
11: guide members
11W: guide members width
11W': (Related art) insertion portion width
11a, 11b: guide pieces
11a', 11b': (Related art) guide members
11a10, 11b10: vertical inner side surface
11a30, 11b30: guide surface
12: extending guide members
12W: extending guide members width
13: support block
13': (Related art) support block
14: support
20: tester pin
20': (Related art) tester pin
200: battery cell
210: lead
300: pressing plate
300': (Related art) pressing plate
F: fixing part
I': (Related art) insertion portion
I: insertion portion

## Claims

1. A tab guide (10) for guiding an electrode lead (210) of a battery cell (200) to a tester pin (20) for inspection of the battery cell, the tab guide (10) comprising:
a tester pin (20) configured to be connected to the electrode lead (210) of the battery cell (200) to measure electrical characteristics of the battery cell (200);
a guide member (11) composed of a pair of guide pieces (11a,11b) disposed side by side at a predetermined interval and facing each other and having the tester pin (20) fixedly installed in the interval at a rear end portion of the guide member (11), wherein inner side surfaces of the pair of guide pieces facing each other include guide surfaces (11a30, 11b30) inclined toward the tester pin (20) from front end portions of the guide pieces (11a,11b); and
a pair of extending guide members (12) installed to protrude from the front end portions of the guide pieces (11a, 11b) to be inclined away from each other in a frontward direction.

2. The tab guide (10) of claim 1, wherein rear end portions of the pair of extending guide members (12) are coupled to the guide surfaces (11a30, 11b30) of the guide pieces (11a,11b), and the pair of extending guide members (12) protrude from the guide member (11) at the same angle as an inclination angle of the guide surfaces (11a30, 11b30).

3. The tab guide (10) of claim 1, wherein:
the pair of guide pieces (11a,11b) respectively have vertical inner side surfaces (11a10, 11b120) extending from the guide surfaces (11a30, 11b30) and disposed to face each other in parallel;
the tester pin (20) is fixedly installed between rear end portions of the vertical inner side surfaces (11a10, 11b120) facing each other; and
front end portions of the vertical inner side surfaces (11a10, 11b120) facing each other form a fixing part (F) configured to fix the electrode lead (210).

4. The tab guide (10) of claim 1, further comprising a support block (13) coupled to a rear surface of the guide member (11).

5. The tab guide (10) of claim 3, wherein outer side surfaces at opposite sides from the inner side surfaces of the pair of guide pieces (11a, 11b) facing each other are formed as vertical surfaces extending parallel to the vertical inner side surfaces (11a10, 11b120).

6. The tab guide (10) of claim 1, wherein rear end portions of the pair of extending guide members (12) are coupled to the front end portions of the guide pieces (11a, 11b).

7. The tab guide (10) of claim 6, wherein the pair of extending guide members (12) protrude from the guide member at an angle the same as or different from an inclination angle of the guide surfaces (11a, 11b).

8. The tab guide (10) of claim 1, wherein the guide member (11) and the extending guide members (12) are formed of different materials.

9. The tab guide (10) of claim 1, wherein the guide member (11) is formed of a metal material.

10. The tab guide (10) of claim 1, wherein the extending guide members (12) are formed of a material having elasticity.

11. The tab guide (10) of claim 4, further comprising a support (14) coupled to a lower portion of the support block (13) and formed to extend in a downward direction.

12. A tab guide device comprising:
a plurality of tab guides (10) of any one of claims 1 to 11 installed side by side along an arrangement direction of a plurality of battery cells (200); and
a connection member in which the plurality of tab guides (10) are slidably installed and extending along the arrangement direction of the battery cells (200).

## Patentansprüche

1. Laschenführung (10) zum Führen einer Elektrodenleitung (210) einer Batteriezelle (200) zu einem Prüfstift (20) zur Prüfung der Batteriezelle, wobei die Laschenführung (10) Folgendes umfasst:
einen Prüfstift (20), der dafür ausgebildet ist, mit der Elektrodenleitung (210) der Batteriezelle (200) verbunden zu werden, um elektrische Eigenschaften der Batteriezelle (200) zu messen;
ein Führungselement (11), das aus einem Paar von Führungsstücken (11a, 11b) gebildet ist, die in einem vorgegebenen Abstand nebeneinander und einander gegenüberliegend angeordnet sind und den Prüfstift (20) in dem Abstand an einem hinteren Endabschnitt des Führungselements (11) fest angeordnet aufweisen, wobei innere Seitenflächen des Paars von Führungsstücken, die einander gegenüberliegen, Führungsflächen (11a30, 11b30) einschließen, die von vorderen Endabschnitten der Führungsstücke (11a, 11b) zu dem Prüfstift (20) hin geneigt sind; und
ein Paar von Verlängerungsführungselementen (12), die so angeordnet sind, dass sie von den vorderen Endabschnitten der Führungsstücke (11a, 11b) vorstehen und in einer Vorwärtsrichtung voneinander weg geneigt sind.

2. Laschenführung (10) nach Anspruch 1, wobei hintere Endabschnitte des Paars von Verlängerungsführungselementen (12) mit den Führungsflächen (11a30, 11b30) der Führungsstücke (11a, 11b) gekoppelt sind, und das Paar von Verlängerungsführungselementen (12) unter demselben Winkel wie ein Neigungswinkel der Führungsflächen (11a30, 11b30) von dem Führungselement (11) vorsteht.

3. Laschenführung (10) nach Anspruch 1, wobei:
das Paar von Führungsstücken (11a, 11b) jeweils vertikale innere Seitenflächen (11a10, 11b120) aufweist, die sich von den Führungsflächen (11a30, 11b30) erstrecken und so angeordnet sind, dass sie einander gegenüberliegend parallel sind;
der Prüfstift (20) zwischen hinteren Endabschnitten der vertikalen inneren Seitenflächen (11a10, 11b120), die einander gegenüberliegen, fest angeordnet ist; und
vordere Endabschnitte der vertikalen inneren Seitenflächen (11a10, 11b120), die einander gegenüberliegen, einen Fixierabschnitt (F) bilden, der dafür ausgebildet ist, die Elektrodenleitung (210) zu fixieren.

4. Laschenführung (10) nach Anspruch 1, weiter umfassend einen Stützblock (13), der mit einer hinteren Fläche des Führungselements (11) gekoppelt ist.

5. Laschenführung (10) nach Anspruch 3, wobei äußere Seitenflächen an den den inneren Seitenflächen des Paars von Führungsstücken (11a, 11b), die einander gegenüberliegen, entgegengesetzten Seiten, als vertikale Flächen gebildet sind, die sich parallel zu den vertikalen inneren Seitenflächen (11a10, 11b120) erstrecken.

6. Laschenführung (10) nach Anspruch 1, wobei hintere Endabschnitte des Paars von Verlängerungsführungselementen (12) mit den vorderen Endabschnitten der Führungsstücke (11a, 11b) gekoppelt sind.

7. Laschenführung (10) nach Anspruch 6, wobei das Paar von Verlängerungsführungselementen (12) von dem Führungselement unter einem Winkel vorsteht, der derselbe wie oder verschieden von einem Neigungswinkel der Führungsflächen (11a, 11b) ist.

8. Laschenführung (10) nach Anspruch 1, wobei das Führungselement (11) und die Verlängerungsführungselemente (12) aus unterschiedlichen Materialien gebildet sind.

9. Laschenführung (10) nach Anspruch 1, wobei das Führungselement (11) aus einem Metallmaterial gebildet ist.

10. Laschenführung (10) nach Anspruch 1, wobei die Verlängerungsführungselemente (12) aus einem Material gebildet sind, das Elastizität aufweist.

11. Laschenführung (10) nach Anspruch 4, weiter umfassend eine Stütze (14), die mit einem unteren Abschnitt des Stützblocks (13) gekoppelt ist und gebildet ist, um sich in einer Abwärtsrichtung zu erstrecken.

12. Laschenführungsvorrichtung, umfassend:
eine Vielzahl von Laschenführungen (10) nach einem der Ansprüche 1 bis 11, die entlang einer Anordnungsrichtung einer Vielzahl von Batteriezellen (200) nebeneinander angeordnet sind; und
ein Verbindungselement, in dem die Vielzahl von Laschenführungen (10) verschiebbar installiert sind und das sich entlang der Anordnungsrichtung der Batteriezellen (200) erstreckt.

## Revendications

1. Guide (10) de languette pour guider un fil (210) d'électrode d'une cellule (200) de batterie vers une broche de test (20) pour inspection de la cellule de batterie, le guide (10) de languette comprenant :
une broche de test (20) configurée pour être reliée au fil (210) d'électrode de la cellule (200) de batterie pour mesurer des caractéristiques électriques de la cellule (200) de batterie ;
un élément de guidage (11) composé d'une paire de pièces de guidage (11a, 11b) disposées côte à côte à un intervalle prédéterminé et se faisant face et présentant la broche de test (20) fixement installée dans l'intervalle au niveau d'une portion d'extrémité arrière de l'élément de guidage (11), dans lequel les surfaces latérales internes de la paire de pièces de guidage se faisant face incluent des surfaces de guidage (11a30, 11b30) inclinées vers la broche de test (20) à partir de portions d'extrémité avant des pièces de guidage (11a, 11b) ; et
une paire d'éléments de guidage d'extension (12) installés pour faire saillie à partir des portions d'extrémité avant des pièces de guidage (11a, 11b) afin d'être inclinés en s'éloignant l'un de l'autre dans une direction vers l'avant.

2. Guide (10) de languette selon la revendication 1, dans lequel les portions d'extrémité arrière de la paire d'éléments de guidage d'extension (12) sont couplées aux surfaces de guidage (11a30, 11b30) des pièces de guidage (11a, 11b), et la paire d'éléments de guidage d'extension (12) fait saillie à partir de l'élément de guidage (11) au même angle qu'un angle d'inclinaison des surfaces de guidage (11a30, 11b30).

3. Guide (10) de languette selon la revendication 1, dans lequel :
la paire de pièces de guidage (11a, 11b) présente respectivement des surfaces latérales internes verticales (11a10, 11b120) s'étendant à partir des surfaces de guidage (11a30, 11b30) et disposées parallèlement en se faisant face ;
la broche de test (20) est fixement installée entre les portions d'extrémité arrière des surfaces latérales internes verticales (11a10, 11b120) se faisant face ; et
les portions d'extrémité avant des surfaces latérales internes verticales (11a10, 11b120) se faisant face forment une partie de fixation (F) configurée pour fixer le fil (210) d'électrode.

4. Guide (10) de languette selon la revendication 1, comprenant en outre un bloc de support (13) couplé à une surface arrière de l'élément de guidage (11).

5. Guide (10) de languette selon la revendication 3, dans lequel les surfaces latérales externes au niveau de côtés opposés par rapport aux surfaces latérales internes de la paire de pièces de guidage (11a, 11b) se faisant face sont formées en tant que surfaces verticales s'étendant parallèlement aux surfaces latérales internes verticales (11a10, 11b120).

6. Guide (10) de languette selon la revendication 1, dans lequel les portions d'extrémité arrière de la paire d'éléments de guidage d'extension (12) sont couplées aux portions d'extrémité avant des pièces de guidage (11a, 11b).

7. Guide (10) de languette selon la revendication 6, dans lequel la paire d'éléments de guidage d'extension (12) fait saillie à partir de l'élément de guidage à un angle identique à ou différent d'un angle d'inclinaison des surfaces de guidage (11a, 11b).

8. Guide (10) de languette selon la revendication 1, dans lequel l'élément de guidage (11) et les éléments de guidage d'extension (12) sont formés de matériaux différents.

9. Guide (10) de languette selon la revendication 1, dans lequel l'élément de guidage (11) est formé d'un matériau métallique.

10. Guide (10) de languette selon la revendication 1, dans lequel les éléments de guidage d'extension (12) sont formés d'un matériau présentant une élasticité.

11. Guide (10) de languette selon la revendication 4, comprenant en outre un support (14) couplé à une portion inférieure du bloc de support (13) et formé pour s'étendre dans une direction vers le bas.

12. Dispositif de guidage de languette comprenant :
une pluralité de guides (10) de languette selon l'une quelconque des revendications 1 à 11 installés côte à côte le long d'une direction d'agencement d'une pluralité de cellules (200) de batterie ; et
un élément de liaison dans lequel la pluralité de guides (10) de languette sont installés de manière coulissante et s'étendant le long de la direction d'agencement des cellules (200) de batterie.
